# EUROPEAN PATENT APPLICATION

(11) **EP 4 661 158 A1**
(43) Date of publication of application: **10.12.2025**
(21) Application number: 24836284.0
(22) Date of filing: 02.07.2024
(51) Int. Cl.: H01M 10/48, G01R 31/392, G01R 31/12, G01R 19/165

(54) **BATTERY PACK AND DIAGNOSIS METHOD THEREFOR**

(30) Priority: 05.07.2023 KR 20230087011
(71) Applicant: LG Energy Solution, Ltd., Seoul 07335 (KR)
(72) Inventor: YOON, Dong Sik, Daejeon 34122 (KR)
(74) Representative: Plasseraud IP
(86) International application number: PCT/KR2024/009261
(87) International publication number: WO 2025/009836

(57) **Abstract**

A battery pack according to an embodiment disclosed herein includes: a battery cell including a pouch configured to cover a cathode material and an anode material, a first terminal, and a second terminal; a connector including a transistor configured to connect the pouch and the first terminal; and a controller configured to measure an inrush current flowing into the connector, and diagnose a state of the battery cell based on the inrush current.

## Description

### [TECHNICAL FIELD]

### CROSS-REFERENCE TO RELATED APPLICATION

This application claims priority to and the benefit of Korean Patent Application No. 10-2023-0087011 filed in the Korean Intellectual Property Office on July 5, 2023, the entire contents of which are incorporated herein by reference.

### TECHNICAL FIELD

Embodiments disclosed herein relate to a battery pack and a method of diagnosing the same.

### [BACKGROUND ART]

As currently commercialized secondary batteries, there are a nickel cadmium battery, a nickel hydrogen battery, a nickel zinc battery, a lithium secondary battery, etc. Among them, the lithium secondary battery is in the limelight because it has advantages that charging and discharging are free due to almost no memory effect, a self-discharge rate is very low, and energy density is high compared to the nickel-based secondary batteries.

Although these secondary batteries are sometimes used as a single secondary battery, they are often used as a plurality of secondary batteries connected in series and/or parallel to provide a high-voltage and/or large-capacity power storage device. Further, the plurality of secondary batteries is used in the form of a battery pack with a battery management system (BMS) for controlling overall charging and discharging operations thereof.

In such a high-voltage and large-capacity power storage device using the secondary batteries, it is very important to maintain insulation. When the insulation is not maintained, a leakage current may occur, thereby shortening the life of the batteries, causing malfunction of electrical devices connected to the batteries, and causing negligent accidents such as an electric shock.

### [DISCLOSURE]

### [TECHNICAL PROBLEM]

An aspect of embodiments disclosed herein is to provide a battery pack and a method of diagnosing the same, in which an insulation breakdown of a battery cell is detectable.

Technical problems of the embodiments disclosed herein are not limited to the forementioned problems, and other unmentioned problems will be clearly understood from the following description by a person having ordinary skill in the art to which the disclosure pertains.

### [Technical Solution]

According to an embodiment disclosed herein, a battery pack includes: a battery cell including a pouch configured to cover a cathode material and an anode material, a first terminal, and a second terminal; a connector including a transistor configured to connect the pouch and the first terminal; and a controller configured to measure an inrush current flowing into the connector, and diagnose a state of the battery cell based on the inrush current.

According to an embodiment, the transistor may be configured to be turned on upon voltage between both ends of the connector being out of a preset range.

According to an embodiment, a current may flow from the connector into the first terminal upon the transistor being turned on during charging of the battery cell.

According to an embodiment, voltage at a node where the connector is in contact with the pouch may be higher than voltage at a node where the connector is in contact with the first terminal, upon the battery cell being charged.

According to an embodiment, a current may flow from the connector into the pouch upon the transistor being turned on during discharging of the battery cell.

According to an embodiment, voltage at a node where the connector is in contact with the pouch may be lower than voltage at a node where the connector is in contact with the first terminal, upon the battery cell being discharged.

According to an embodiment, the preset range may be set based on a voltage difference between the first terminal and the second terminal.

According to an embodiment, the battery pack may further include a conducting portion placed on one side of the pouch, wherein the connector may be configured to connect the first terminal and the pouch.

According to an embodiment, the controller may be configured to identify that the battery cell is in an insulation breakdown state, upon the inrush current having a magnitude higher than or equal to a preset value.

According to an embodiment, the battery pack may further include an additional battery cell electrically connected to the battery cell, wherein the controller may be configured to cut off the battery cell by electrically separating the battery cell from the additional battery cell.

According to an embodiment, the controller may be configured to inform a user of an insulation breakdown of the battery cell.

According to an embodiment disclosed herein, a battery diagnosis method includes: connecting a first terminal and a pouch of a battery cell by a transistor, the battery cell including the pouch configured to cover a cathode material and an anode material, the first terminal, and a second terminal; measuring an inrush current flowing into the transistor; and diagnosing a state of the battery cell based on the inrush current flowing into the transistor.

According to an embodiment, the diagnosis may include identifying that the battery cell is in an insulation breakdown state, upon the inrush current flowing into the transistor having a magnitude higher than or equal to a preset value.

According to an embodiment, the battery diagnosis method may further include cutting off the battery cell by electrically separating the battery cell from an additional battery cell electrically connected to the battery cell, after the diagnosis.

According to an embodiment, the battery diagnosis method may further include informing a user of an insulation breakdown of the battery cell, after the cutting-off.

According to an embodiment, the transistor may be turned on upon voltage between both ends of the transistor being out of a preset range.

According to an embodiment, voltage at a node where the transistor is in contact with the pouch may be higher than voltage at a node where the transistor is in contact with the first terminal, upon the battery cell being charged, and a current may flow from the transistor into the first terminal upon the transistor being turned on.

According to an embodiment, voltage at a node where the transistor is in contact with the pouch may be lower than voltage at a node where the transistor is in contact with the first terminal, upon the battery cell being discharged, and a current may flow from the transistor into the pouch upon the transistor being turned on.

According to an embodiment, the preset range may be set based on a voltage difference between the first terminal and the second terminal.

Details of other embodiments are included in the detailed descriptions and the accompanying drawings.

### [ADVANTAGEOUS EFFECTS]

In a battery pack according to embodiments disclosed herein and a diagnosis method thereof, an insulation breakdown of a battery cell is diagnosed.

In a battery pack according to embodiments disclosed herein and a diagnosis method thereof, an insulation breakdown of a battery cell is diagnosed during charging and discharging of the battery pack without destroying the battery pack.

The effects of a battery pack according to embodiments disclosed herein and a diagnosis method thereof are not limited to the foregoing effects, and other unmentioned effects will be clearly understood from the following description by those skilled in the art.

### [DESCRIPTION OF DRAWINGS]

FIG. 1 is a block diagram showing a battery control system according to an embodiment disclosed herein.
FIG. 2 is a schematic view showing battery cells and a connector according to an embodiment disclosed herein.
FIG. 3 is a graph showing a pouch voltage of a battery cell according to an embodiment disclosed herein when the battery cell is in a normal state.
FIG. 4 is a graph showing a pouch voltage of a battery cell according to an embodiment disclosed herein when the battery cell is in an abnormal state.
FIG. 5 is a graph showing an inrush current based on a pouch voltage in a charging state of a battery cell according to an embodiment disclosed herein.
FIG. 6 is a graph showing an inrush current based on a pouch voltage in a discharging state of a battery cell according to an embodiment disclosed herein.
FIG. 7 is a flowchart showing a battery diagnosis method according to an embodiment disclosed herein.
FIG. 8 is a block diagram showing a computing system for implementing a battery diagnosis method according to an embodiment disclosed herein.

Regarding the description of the drawings, the same or similar reference numerals may refer to the same or similar elements.

### [MODE FOR INVENTION]

Hereinafter, embodiments of the disclosure will be described with reference to the accompanying drawings. However, the description is not intended to limit the disclosure to the specific embodiments, and the embodiments of the disclosure should be construed as including all modifications, equivalents and/or substitutes.

The embodiments of the disclosure and terms used herein do not limit the technical features described in the disclosure to the specific embodiment, and should be construed as including various modifications, equivalents or substitutes thereof. Regarding the description of the drawings, similar reference numerals may be used to refer to similar or related elements. It is to be understood that a singular form of a noun corresponding to an item may include one or more of the things, unless the relevant context clearly indicates otherwise.

In the disclosure, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "first," "second," "1^{st}," "2^{nd}," "A", "B", "(a)" or "(b)" may be used to simply distinguish a corresponding element from another, and does not limit the elements in other aspect (e.g., importance or order) unless specifically stated to the contrary.

It is to be understood that if an element (e.g., a first element) is referred to, with or without the term "operatively" or "communicatively", as "connected to," "coupled to," "joined to" another element (e.g., a second element), the element may be connected to the other element directly (e.g., by a wire or wirelessly) or indirectly (e.g., via a third element).

A method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store or between two user devices directly. If distributed online, at least part of the computer program product may be temporarily generated or at least temporarily stored in the machine-readable storage medium, such as a memory of the manufacturer's server, a server of the application store, or a relay server.

According to various embodiments, each element (e.g., a module or a program) of the above-described elements may include a single entity or multiple entities. Some of the plurality of entities may be separately placed in another elements. According to various embodiments disclosed herein, one or more elements or operations of the above-described elements may be omitted, or one or more other elements or operations may be added. Alternatively or additionally, a plurality of elements (e.g., modules or programs) may be integrated into a single element. In such a case, the integrated element may still perform one or more functions of each of the plurality of elements in the same or similar manner as they are performed by a corresponding one of the plurality of elements before the integration. According to embodiments disclosed herein, operations performed by the module, the program, or another element may be carried out sequentially, in parallel, repeatedly, or heuristically, or one or more of the operations may be executed in a different order or omitted, or one or more other operations may be added.

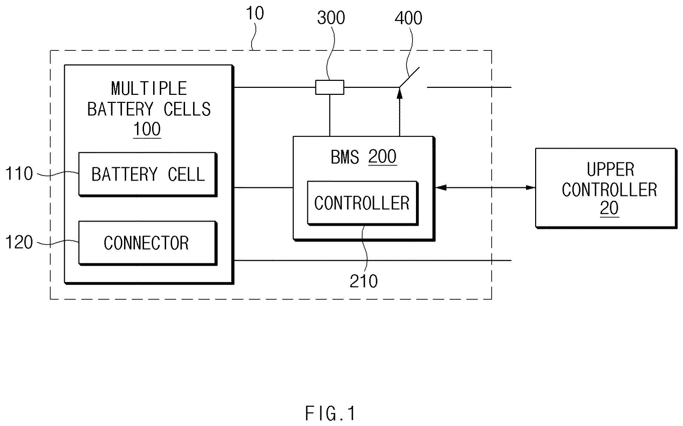

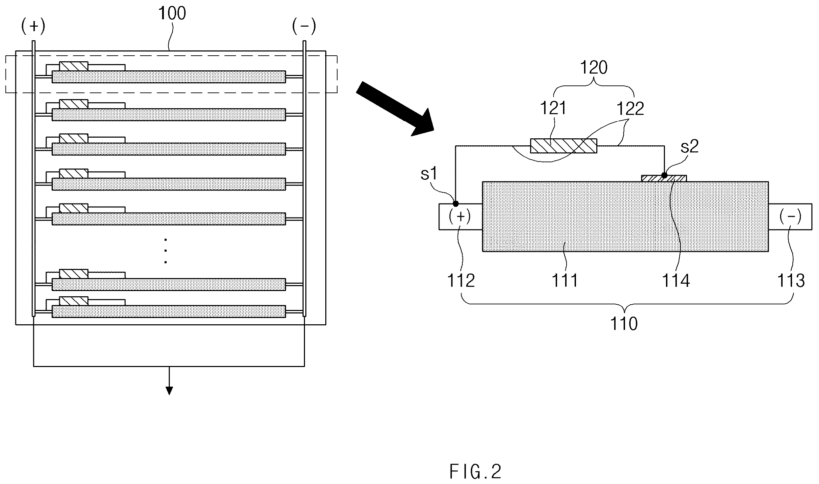

FIG. 1 is a block diagram showing a battery control system according to an embodiment disclosed herein. FIG. 2 is a schematic view showing battery cells and a connector according to an embodiment disclosed herein.

Referring to FIG. 1, the battery control system may include a battery pack and a higher-level controller.

A battery pack 10 may include a plurality of battery cells 100, a switching unit 400 connected in series to a first terminal 112 and/or a second terminal 113 of a battery cell 110 and configured to control the charging and discharging current of the battery cell 110, and a battery management system 200 configured to monitor the voltage, current, temperature, etc. of the battery pack 10 and prevent overcharging and overdischarging.

The battery pack 10 may include the battery cell 110, a sensor 300, the switching unit 400, and the battery management system 200. Here, the switching unit 400 refers to a device for controlling the charging or discharging current of the plurality of battery cells 110, which may for example employ at least one relay, magnetic contactor, etc. according to the specifications of the battery pack 10. The sensor 300 may be connected to the plurality of battery cells 100 and configured to obtain information about the plurality of battery cells 100. Further, the sensor 300 may transmit the information obtained from the plurality of battery cells 100 to the battery management system 200.

The battery management system 200 refers to an interface for receiving measured values of various parameters described above, which may include a plurality of terminals, a controller 210 connected to these terminals and configured to process input values, a circuitry, etc. Further, the battery management system 200 may be configured to control ON/OFF of the switching unit 400, and may be connected to each battery cell 110 and configured to monitor the state of each battery cell 110.

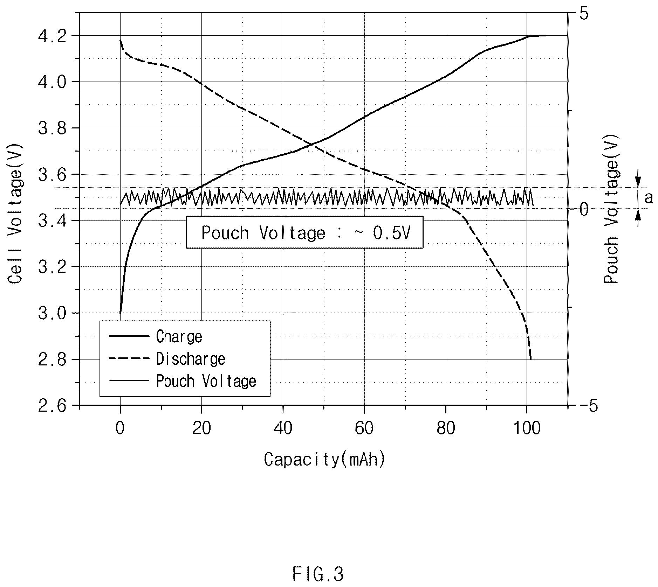

The controller 210 may be configured to diagnose the plurality of battery cells 100. The controller 210 may be configured to measure the current of each connector 120 included in each of the plurality of battery cells 100, and diagnose the state of each battery cell 110. Here, the current of the connector 120 may be defined as an inrush current. In this regard, details will be described with reference to FIGS. 3 to 6.

When the battery cell 110 is diagnosed as abnormal, the controller 210 may be configured to provide information about that battery cell 110 to a user. For example, the controller 210 may be configured to not only provide information about the abnormal battery cell 110 to a user terminal through a communication unit (not shown) but also provide information about the abnormal battery cell 110 through a display provided in a vehicle, a charger, etc.

An upper controller 20 may be configured to transmit a control signal for the battery cell 110 to the battery management system 200. Therefore, the operations of the battery management system 200 may be controlled based on the signal transmitted from the upper controller 20.

According to an embodiment, the battery management system 200 may include the controller 210 of FIG. 1. According to an alternative embodiment, the battery management system 200 may be a system different from the controller 210 of FIG. 1. The following operations of the controller 210 may be performed by various devices such as a server, a cloud, and a charger or a charger/discharger, as well as a built-in battery management system (BMS) of a vehicle.

Referring to FIG. 2, the plurality of battery cells 100 may include the battery cell 110 and the connector 120. Further, each battery cell 110 may include a pouch 111, the first terminal 112, and the second terminal 113. Here, the pouch 111 may refer to a casing of the battery cell 110, which is configured to cover a cathode material, an anode material, a separator, and an electrolyte of the battery. Thus, the pouch 111 may form the outer appearance of the battery cell 110.

The first terminal 112 may be a (+) terminal of the battery cell 110, and the second terminal 113 may be a (-) terminal. According to an embodiment, the first terminal 112 and the second terminal 113 may protrude out of the pouch 111. In other words, the first terminal 112 and the second terminal 113 may not be covered with the pouch 111.

The connector 120 may be configured to connect the first terminal 112 and the pouch 111 or the second terminal 113 and the pouch 111. In other words, the connector 120 may connect the first terminal 112 and the pouch 111, or may connect the second terminal 113 and the pouch 111. For convenience of description, description will be made on the assumption that the connector 120 connects the first terminal 112 and the pouch 111.

The connector 120 may include a transistor 121 and a conducting wire 122. According to an embodiment, the transistor 121 may be, but not limited to, a bipolar junction transistor (BJT). The transistor 121 may be configured to perform current amplification or switching function based on voltage applied to both terminals of the transistor 121.

The transistor 121 may connect the first terminal 112 and one side of the pouch 111. Specifically, the conducting wire 122 may be configured to connect the first terminal 112 and the transistor 121 and connect the transistor 121 and one side of the pouch 111. In other words, the transistor 121 may use the conducting wire 122 to connect the first terminal 112 and one side of the pouch 111.

According to an embodiment, a conducting portion 114 may be placed on one side of the pouch 111. Here, the conducting portion 114 may contain metal or the like material having electrical conductivity. In this case, the transistor 121 may connect the first terminal 112 and the conducting portion 114 of the battery cell 110.

A spot where the connector 120 is in contact with the first terminal 112 may be defined as a first node s1. Further, a spot where the connector 120 is in contact with one side of the pouch 111 or the conducting portion 114 may be defined as a second node s2.

The connector 120 be configured to operate based on voltage between the first node s1 and the second node s2. For example, the transistor 121 included in the connector 120 may be configured to be turned on when the voltage the first node s1 and the second node s2 is out of a preset range. In other words, the transistor 121 may be configured not to operate when the voltage between the first node s1 and the second node s2 is within the preset range, but to be turned on when the voltage between the first node s1 and the second node s2 is out of the preset range. Here, the voltage between the first node s1 and the second node s2 may be defined as a pouch voltage (i.e., the voltage corresponding to the pouch 111). In other words, the pouch voltage may refer to a value obtained by subtracting the voltage of the first node s1 from the voltage of the second node s2.

The preset range may be set in consideration of a voltage difference between the first terminal 112 and the second terminal 113 and a driving voltage for the transistor 121. For example, when the voltage difference between the first terminal 112 and the second terminal 113 is large, the preset range may be set wide. When the voltage difference between the first terminal 112 and the second terminal 113 is small, the preset range may be set narrow. Further, the upper and lower limits of the preset range may be set based on the driving voltage for the transistor 121. In other words, a preset range a may be set to operate the transistor 121 when the pouch voltage is out of the preset range.

FIG. 3 is a graph showing a pouch voltage of a battery cell according to an embodiment disclosed herein when the battery cell is in a normal state.

Referring to FIG. 3, the controller 210 may be configured to obtain voltage information about the battery cell 110. Here, the voltage information about the battery cell 110 may include a charging voltage, a discharging voltage, and a pouch voltage. The charging voltage may refer to a voltage between the first terminal 112 and the second terminal 113 of the battery cell 110 based on the charging of the battery cell 110. As the charging progresses, the charging voltage may increase. The discharging voltage may refer to a voltage between the first terminal 112 and the second terminal 113 of the battery cell 110 based on the discharging of the battery cell 110. As the discharging progresses, the discharging voltage may decrease.

The pouch voltage may refer to a voltage between the first terminal 112 and the pouch 111 of the battery cell 110. In other words, the pouch voltage may refer to a voltage between the first node s1 where the connector 120 and the first terminal 112 are connected, and the second node s2 where the connector 120 and one side of the pouch 111 are connected. When the battery cell 110 is in the normal state, the insulation of the pouch 111 is maintained. Thus, the second node s2 may serve as resistance on an equivalent circuit. Therefore, the pouch voltage is maintained within a certain range regardless of the charging or discharging of the battery cell 110. Here, the certain range may correspond to the foregoing preset range a. In other words, the pouch voltage may vary within the preset range a while the battery is being charged or discharged. According to an embodiment, the preset range a may range from 0 [V] to 0.5 [V].

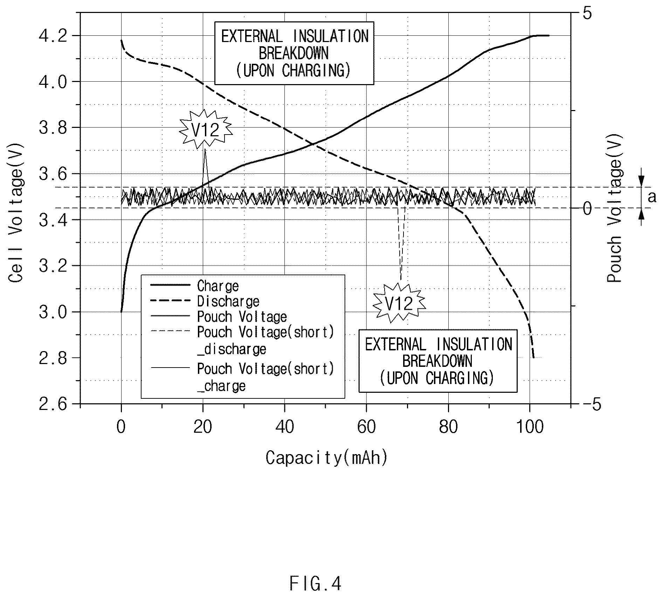

FIG. 4 is a graph showing a pouch voltage of a battery cell according to an embodiment disclosed herein when the battery cell is in an abnormal state.

Referring to FIG. 4, the pouch voltage may be out of the preset range a according to the states of the battery cell 110. When the insulation of the pouch 111 of the battery cell 110 breaks down, the pouch 111 may come into contact with the electrolyte inside the pouch 111. According to an embodiment, the pouch 111 may include an aluminum layer, and thus the voltage of the second node s2 may be affected by the electrolyte as the aluminum layer is in contact with the electrolyte. Thus, the second node s2 may serve as a voltage source on an equivalent circuit. In other words, the voltage at the second node s2 may be varied, and the voltage between the first node s1 and the second node s2, i.e., the pouch voltage may also be varied.

Specifically, when the pouch voltage is measured while the battery cell 110, of which the insulation has broken down, is being charged, the pouch voltage may be out of the preset range a. The pouch voltage in this case may be defined as a first voltage V12. The insulation breakdown of the battery cell 110 may cause a short-circuit between the pouch 111 and the electrolyte inside the pouch 111, and thus the electrolyte causes the voltage of the second node s2 to increase compared to the voltage of the first node s1. Therefore, the voltage difference between the second node s2 and the first node s1, i.e., the pouch voltage may increase beyond the preset range a. In other words, the first voltage V12 may be out of the preset range a. According to an embodiment, the first voltage V12 may be higher than or equal to 0.5 [V].

When the pouch voltage is measured while the battery cell 110, of which the insulation has broken down, is being discharged, the pouch voltage may be out of the preset range a. The pouch voltage in this case may be defined as a second voltage V12. The insulation breakdown of the battery cell 110 may cause a short-circuit between the pouch 111 and the electrolyte inside the pouch 111, and thus the electrolyte causes the voltage of the second node s2 to decrease compared to the voltage of the first node s1. Therefore, the voltage difference between the second node s2 and the first node s1, i.e., the pouch voltage may decrease beyond the preset range a. In other words, the second voltage V12 may be out of the preset range a. According to an embodiment, the second voltage V12 may be lower than 0 [V].

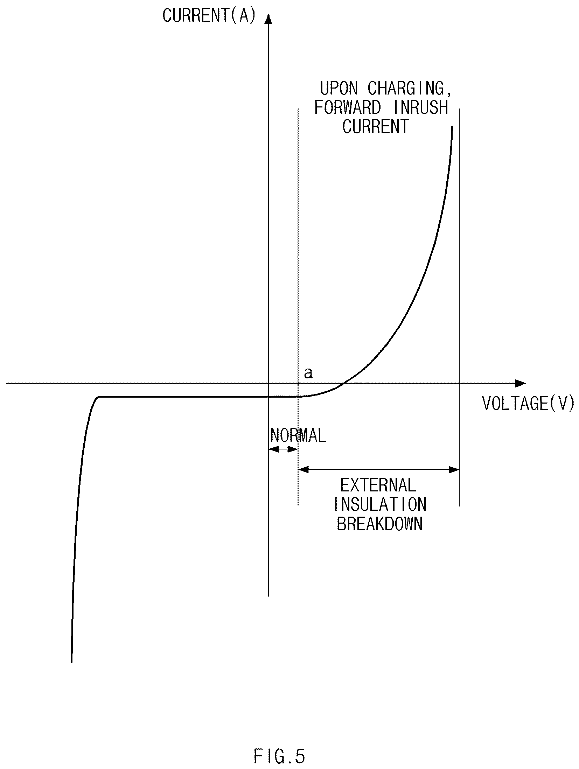

FIG. 5 is a graph showing an inrush current based on a pouch voltage in a charging state of a battery cell according to an embodiment disclosed herein.

Referring to FIG. 5, the inrush current may be generated based on the pouch voltage while the battery cell 110 is charged. In the graph shown in FIG. 5, the abscissa corresponds to the pouch voltage, and the ordinate corresponds to the inrush current.

When the pouch voltage is within the preset range a, the transistor 121 may be in an OFF state. Thus, the magnitude of the inrush current may be constant. According to an embodiment, when the transistor 121 is in the OFF state, the magnitude of the inrush current may be lower than or equal to a preset value.

When the magnitude of the inrush current is lower than or equal to the preset value, the controller 210 may identify that the battery cell 110 is in the normal state. According to an embodiment, when the magnitude of the inrush current is lower than or equal to the preset value, the controller 210 may identify that the insulation of the battery cell 110 is in the normal state.

When the pouch voltage is out of the preset range a, the transistor 121 may be turned on. Thus, the voltage at the second node s2 increases due to the electrolyte, and the voltage difference between the second node s2 and the first node s1 increases, thereby increasing the pouch voltage. Therefore, the pouch voltage becomes out of the preset range a and the transistor 121 is turned on, thereby generating a forward inrush current. Here, the forward inrush current may refer to a current that flows from the pouch 111 to the first terminal 112 via the connector 120.

When the forward inrush current is higher than a preset value, the controller 210 may identify that the battery cell 110 is in the abnormal state. In other words, the controller 210 may identify the state of the battery cell 110 based on the magnitude of the inrush current. According to an embodiment, when the magnitude of the inrush current is equal to or higher than the preset value, the controller 210 may identify that the insulation of the battery cell 110 is in the breakdown state.

According to an alternative embodiment, the controller 210 may identify the state of the battery cell 110 based on a change rate of the inrush current. In this case, the controller 210 may identify that the batter cell 110 is in the abnormal state when a differential value of the inrush current is higher than or equal to a preset value.

When the insulation breakdown of the battery cell 110 is identified, the controller 210 may transmit information about that battery cell 110 to a user. Here, the information about the battery cell 110 may include an identification number, an insulation state, a magnitude of inrush current, etc. of the battery cell 110.

The controller 210 may cut off the battery cell 110 identified to be in the insulation breakdown state. According to an embodiment, the controller 210 may open a switch (not shown) connecting the battery cell 110 identified to be in the insulation breakdown state and additional battery cells, thereby electrically separating the battery cell 110 identified to be in the insulation breakdown state from the additional battery cells. Here, the additional battery cells may refer to the battery cells 110 other than the battery cell 110 identified to be in the insulation breakdown state among the plurality of battery cells 100.

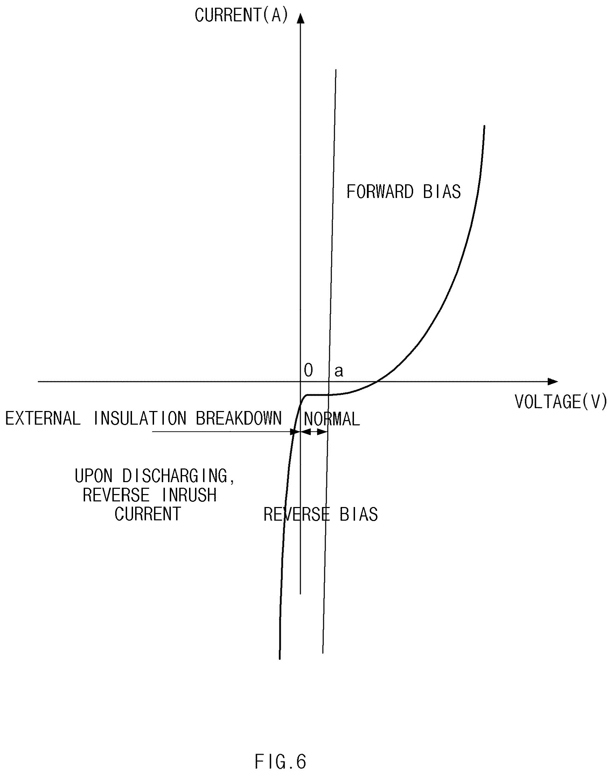

FIG. 6 is a graph showing an inrush current based on a pouch voltage in a discharging state of a battery cell according to an embodiment disclosed herein.

Referring to FIG. 6, the inrush current may be generated based on the pouch voltage while the battery cell 110 is discharged. In the graph shown in FIG. 6, the abscissa corresponds to the pouch voltage, and the ordinate corresponds to the inrush current.

When the pouch voltage is within the preset range a, the transistor 121 may be in the OFF state. Thus, the magnitude of the inrush current may be constant. According to an embodiment, when the transistor 121 is in the OFF state, the magnitude of the inrush current may be lower than or equal to a preset value.

When the magnitude of the inrush current is lower than or equal to the preset value, the controller 210 may identify that the battery cell 110 is in the normal state. According to an embodiment, when the magnitude of the inrush current is lower than or equal to the preset value, the controller 210 may identify that the insulation of the battery cell 110 is in the normal state.

When the pouch voltage is out of the preset range a, the transistor 121 may be turned on. Thus, the voltage at the second node s2 decreases due to the electrolyte, and becomes lower than the voltage at the first node s1, thereby causing the pouch voltage to become out of the preset range. Therefore, the transistor 121 is turned on, thereby generating a reverse inrush current. Here, the reverse inrush current may refer to a current that flows from the first terminal 112 to the pouch 111 via the connector 120.

When the reverse inrush current is higher than a preset value, the controller 210 may identify that the battery cell 110 is in the abnormal state. In other words, the controller 210 may identify the state of the battery cell 110 based on the magnitude of the inrush current. According to an embodiment, when the magnitude of the inrush current is equal to or higher than the preset value, the controller 210 may identify that the insulation of the battery cell 110 is in the breakdown state.

According to an alternative embodiment, the controller 210 may identify the state of the battery cell 110 based on a change rate of the inrush current. In this case, the controller 210 may identify that the batter cell 110 is in the abnormal state when a differential value of the inrush current is higher than or equal to a preset value.

The controller 210 may inform a user of the state of the battery cell 110 or cut off the battery cell 110 even when the battery cell 110 is being discharged like when it is being charged.

According to an embodiment, the battery pack 10 may connect the first terminal 112 and the pouch 111 by the connector 120 in each of the plurality of battery cells 100, and measure the current of the connector 120, thereby diagnosing each individual insulation breakdown of the battery cells 110 included in the battery pack 10. In other words, each individual state of the plurality of battery cells 100 included in the battery pack 10 may be diagnosed based on the current of the connector 120 during the charging or discharging of the battery pack 10 without separate destruction or disassembly of the battery pack 10. Further, the state of the battery cell 110 may be diagnosed simultaneously with the charging or discharging of the battery pack 10, thereby immediately cutting off the battery cell 110 of which the insulation has broken down as the battery pack 10 is charged or discharged, or informing a user of the insulation breakdown so that s/he can take an immediate measure. Accordingly, the battery cell 110 being in the insulation breakdown state is prevented from generating heat, exploding, etc. due to the continued charging or discharging.

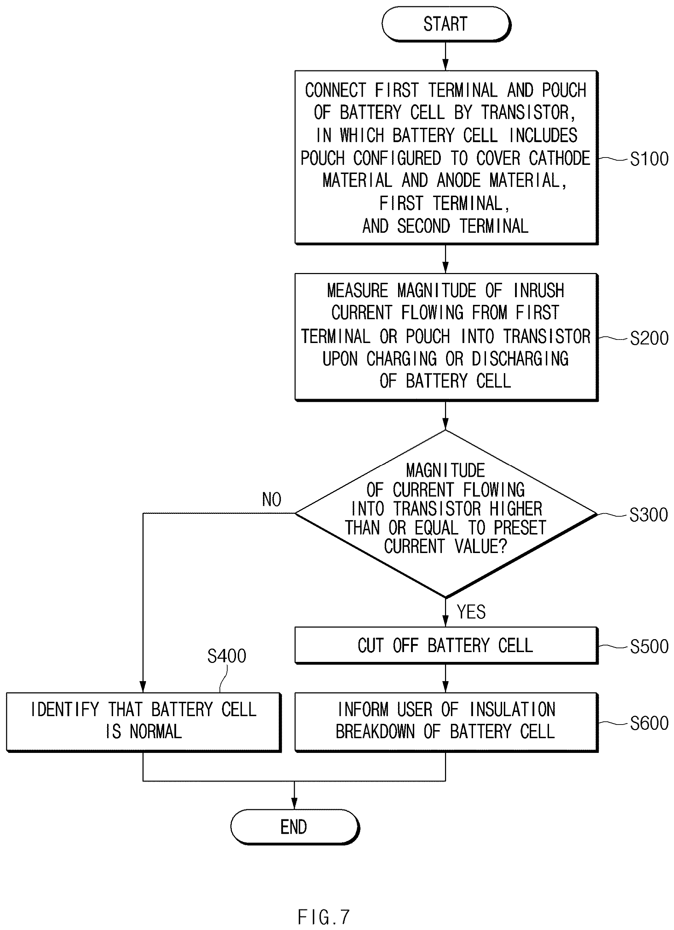

FIG. 7 is a flowchart showing a battery diagnosis method according to an embodiment disclosed herein.

The embodiment shown in FIG. 7 is merely an example, and the sequence of operations according to various embodiments of the disclosure may be different from that shown in FIG. 7. For example, some operations shown in FIG. 7 may be omitted, changed in the sequence, or merged.

Referring to FIG. 7, the battery diagnosis method may include operations of connecting the first terminal 112 and the pouch 111 of the battery cell 110 by the transistor 121, in which the battery cell 110 includes the pouch 111 configured to cover the cathode material and the anode material, the first terminal 112, and the second terminal 113 (S100); measuring the magnitude of the inrush current flowing from the first terminal 112 or the pouch 111 into the transistor 121 while the battery cell 110 is being charged or discharged (S200); identifying whether the magnitude of the current flowing into the transistor 121 is higher than or equal to a preset current value (S300); identifying that the battery cell 110 is normal (S400); cutting off the battery cell 110 (S500); and informing a user of the insulation breakdown of the battery cell 110 (S600).

Below, the operations S100 to S600 will be described in detail with reference to FIGS. 1 to 6.

At operation S100, the battery pack 10 may be configured to connect the first terminal 112 and the pouch 111 of the battery cell 110 by the transistor 121, in which the battery cell 110 includes the pouch 111 configured to cover the cathode material and the anode material, the first terminal 112, and the second terminal 113. According to an embodiment, the battery pack 10 may include the transistor 121, and the transistor 121 may be configured to connect each first terminal 112 of the battery cell 110 and the pouch 111 or connect the first terminal 112 and the conducting portion 114 placed on the pouch 111. According to an embodiment, the first terminal 112 of each battery cell 110, the transistor 121, and the pouch 111 may be connected in a process of manufacturing the battery pack 10.

In the operation S200, the battery pack 10 may measure the magnitude of the inrush current flowing from the first terminal 112 or the pouch 111 into the transistor 121 while the battery cell 110 is being charged or discharged. The battery pack 10 may measure the magnitude of the inrush current flowing from the pouch 111 to the connector 120 or flowing from the first terminal 112 to the connector 120 based on the pouch voltage during the charging or discharging of the battery pack 10.

In the operation S300, the battery pack 10 may identify whether the magnitude of the current flowing into the transistor 121 is higher than or equal to the preset current value. When the magnitude of the inrush current is higher than or equal to the preset current value, the battery pack 10 may perform the operation S500. When the magnitude of the inrush current is lower than the preset current value, the battery pack 10 may perform the operation S400. According to an alternative embodiment, the battery pack 10 may also identify the state of the battery cell 110 based on the change rate of the inrush current. In other words, the battery pack 10 in this case may perform the operation S500 when the change rate of the inrush current is higher than or equal to a preset value, and perform the operation S400 when the change rate of the inrush current is lower than the preset value.

In the operation S400, the battery pack 10 may identify that the battery cell 110 is normal. In other words, the battery pack 10 may identify that the insulation of the battery cell 110 is in the normal state.

In the operation S500, the battery pack 10 may cut off the battery cell 110. In other words, the battery pack 10 may identify that the battery cell 110 is in the insulation breakdown state. According to an embodiment, the battery pack 10 may open the switch (not shown) connecting the battery cell 110 identified to be in the insulation breakdown state and the additional battery cells, thereby electrically separating the battery cell 110 identified to be in the insulation breakdown state from the additional battery cells. Here, the additional battery cells may refer to the battery cells 110 other than the battery cell 110 identified to be in the insulation breakdown state among the plurality of battery cells 100.

In the operation S600, the battery pack 10 may inform a user of the insulation breakdown of the battery cell 110. When the battery cell 110 is identified to be in the insulation breakdown state, the battery pack 10 may be configured to transmit information about that battery cell 110 to a user. For example, the battery pack 10 may be configured to not only provide information about the abnormal battery cell 110 to a user terminal through the communication unit (not shown) but also provide information about the abnormal battery cell 110 through a display provided in a vehicle, a charger, etc. Here, the information about the battery cell 110 may include an identification number, an insulation state, a magnitude of inrush current, etc. of the battery cell 110.

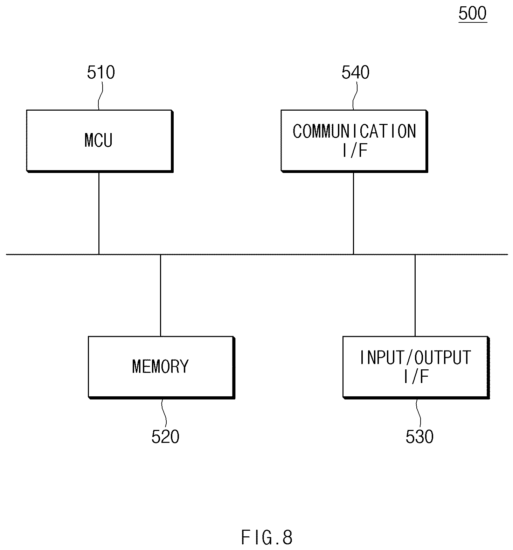

FIG. 8 is a block diagram showing a computing system for implementing a battery diagnosis method according to an embodiment disclosed herein.

Referring to FIG. 8, a computing system 500 according to an embodiment disclosed herein may include a micro controller unit (MCU) 510, a memory 520, an input/output interface (I/F) 530, and a communication I/F 540.

The MCU 510 may refer to a processor that executes various programs (for example, a state of health (SOH) calculation program, a cell balancing target identifying program, etc.) stored in the memory 520, processes various pieces of data including the state of charge (SOC), SOH, etc. of the plurality of battery cells through such programs, and implements the functions of the battery pack 10 described above with reference to FIGS. 1 to 6.

The memory 520 may be configured to store various programs related to the SOH calculation and the cell balancing target identification of the battery cells. Further, the memory 520 may be configured to store various pieces of data, such as the SOC and SOH of each battery cell.

The memory 520 may include a plurality of memories 520 as necessary. The memory 520 may include a volatile memory or a nonvolatile memory. As the volatile memory, the memory 520 may employ a random access memory (RAM), a dynamic RAM (DRAM), a static RAM (SRAM), etc. As the nonvolatile memory, the memory 520 may employ a read only memory (ROM), a programmable ROM (PROM), an electrically alterable ROM (EAROM), an erasable and programmable ROM (EPROM), an electrically erasable and programmable ROM (EEPROM), a flash memory, etc. The memories 520 listed above are merely examples, and are not limited to these examples.

The input/output I/F 530 may provide an interface that connects a keyboard, a mouse, a touch panel, or the like input unit (not shown), a display (not shown) or the like output unit, and the MCU 510 to transmit and receive data.

The communication I/F 540 may refer to various devices that support wired or wireless communication as an element for transmitting and receiving various pieces of data to and from the server. For example, programs, various pieces of data, etc. for calculating the SOH of the battery cell or identifying the balancing target may be transmitted to or received from a separately provided external server through the communication IF 540.

In this way, the battery diagnosis method according to an embodiment disclosed herein may be recorded in the memory 520 and executed by the MCU 510.

The foregoing description is merely an illustrative description of the technical spirit disclosed herein, and various modifications and changes can be made by a person having ordinary knowledge in the art, to which the embodiments disclosed herein pertains, without departing from the scope of essential features of the embodiments disclosed herein.

Accordingly, the embodiments disclosed herein are intended not to limit but rather to illustrate the technical spirit of the disclosure. The scope of the technical sprit disclosed herein is not limited by these embodiments. The scope of the technical sprit disclosed herein should be interpreted based on the appended claims, and all the technical spirits within the equivalent scope should be construed as falling within the scope of the disclosure.

### [DESCRIPTION OF REFERENCE NUMERALS]

10: battery pack
100: plurality of battery cells
110: battery cell
120: connector
121: transistor
210: controller

## Claims

1. A battery pack comprising:
a battery cell comprising a pouch configured to cover a cathode material and an anode material, a first terminal, and a second terminal;
a connector comprising a transistor configured to connect the pouch and the first terminal; and
a controller configured to measure an inrush current flowing into the connector, and diagnose a state of the battery cell based on the inrush current.

2. The battery pack of claim 1, wherein the transistor is configured to be turned on upon voltage between both ends of the connector being out of a preset range.

3. The battery pack of claim 2, wherein a current flows from the connector into the first terminal upon the transistor being turned on during charging of the battery cell.

4. The battery pack of claim 2, wherein voltage at a node where the connector is in contact with the pouch is higher than voltage at a node where the connector is in contact with the first terminal, upon the battery cell being charged.

5. The battery pack of claim 2, wherein a current flows from the connector into the pouch upon the transistor being turned on during discharging of the battery cell.

6. The battery pack of claim 2, wherein voltage at a node where the connector is in contact with the pouch is lower than voltage at a node where the connector is in contact with the first terminal, upon the battery cell being discharged.

7. The battery pack of claim 2, wherein the preset range is set based on a voltage difference between the first terminal and the second terminal.

8. The battery pack of claim 1, further comprising a conducting portion placed on one side of the pouch,
wherein the connector is configured to connect the first terminal and the pouch.

9. The battery pack of claim 1, wherein the controller is configured to identify that the battery cell is in an insulation breakdown state, upon the inrush current having a magnitude higher than or equal to a preset value.

10. The battery pack of claim 9, further comprising an additional battery cell electrically connected to the battery cell,
wherein the controller is configured to cut off the battery cell by electrically separating the battery cell from the additional battery cell.

11. The battery pack of claim 10, wherein the controller is configured to inform a user of an insulation breakdown of the battery cell.

12. A battery diagnosis method comprising:
connecting a first terminal and a pouch of a battery cell by a transistor, the battery cell comprising the pouch configured to cover a cathode material and an anode material, the first terminal, and a second terminal;
measuring an inrush current flowing into the transistor; and
diagnosing a state of the battery cell based on the inrush current flowing into the transistor.

13. The method of claim 12, wherein the diagnosis comprises identifying that the battery cell is in an insulation breakdown state, upon the inrush current flowing into the transistor having a magnitude higher than or equal to a preset value.

14. The method of claim 13, further comprising cutting off the battery cell by electrically separating the battery cell from an additional battery cell electrically connected to the battery cell, after the diagnosis.

15. The method of claim 14, further comprising informing a user of an insulation breakdown of the battery cell, after the cutting-off.

16. The method of claim 12, wherein the transistor is turned on upon voltage between both ends of the transistor being out of a preset range.

17. The method of claim 16, wherein
voltage at a node where the transistor is in contact with the pouch is higher than voltage at a node where the transistor is in contact with the first terminal, upon the battery cell being charged, and
a current flows from the transistor into the first terminal upon the transistor being turned on.

18. The method of claim 16, wherein
voltage at a node where the transistor is in contact with the pouch is lower than voltage at a node where the transistor is in contact with the first terminal, upon the battery cell being discharged, and
a current flows from the transistor into the pouch upon the transistor being turned on.

19. The method of claim 16, wherein the preset range is set based on a voltage difference between the first terminal and the second terminal.
